# EUROPEAN PATENT SPECIFICATION

(11) **EP 3 316 384 B1**
(45) Date of publication and mention of the grant of the patent: **20.02.2019**
(21) Application number: 16195595.0
(22) Date of filing: 25.10.2016
(51) Int. Cl.: H01M 10/42, H05K 1/00, H01M 10/625, H01M 10/637

(54) **BATTERY MODULE WITH A FIXING FOR A TEMPERATURE SENSITIVE ELEMENT**
BATTERIEMODUL MIT EINER BEFESTIGUNG FÜR EIN TEMPERATUREMPFINDLICHES ELEMENT
MODULE DE BATTERIE AVEC FIXATION POUR UN ÉLÉMENT SENSIBLE À LA TEMPÉRATURE

(43) Date of publication of application: 02.05.2018
(73) Proprietor: Samsung SDI Co., Ltd., Giheung-gu Yongin-si, Gyeonggi-do 17084 (KR)
(72) Inventor: Hammerschied, Helmut, 8020 Graz (AT); Hofer, Maximilian, 8230 Hartberg (AT); Cotic, Urban, 2344 Lovrenc na Pohorju (SI)
(74) Representative: Gulde & Partner

(56) References cited:
- US-A1- 2011 039 134
- US-A1- 2012 019 061
- US-A1- 2012 121 940
- US-A1- 2012 251 849
- US-A1- 2013 164 569
- US-A1- 2014 147 705

## Description

### Field of the Invention

The present invention relates to a battery module comprising a specific arrangement of a fixing between a protective circuit module and a temperature sensitive element suitable for measurement of a battery cell temperature.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs each battery is coupled to a common current collector structure and a common battery management system and the unit thereof is housed. In modular designs, pluralities of battery cells are connected to form submodules and several submodules are connected to form the module. The battery management functions can then be at least partially realized on either module or submodule level and thus interchangeability might be improved. One or more battery modules are mechanically and electrically integrated, equipped with a thermal management system and set up for communication with one or more electrical consumers in order to form a battery system. The thermal management system includes usually a protective circuit module which is arranged next to the battery cells.

For meeting the dynamic power demands of various electrical consumers connected to the battery system a static control of battery power output and charging is not sufficient. Thus, steady exchange of information between the battery system and the controllers of the electrical consumers is required. These information includes the battery systems actual state of charge (SoC), potential electrical performance, charging ability and internal resistance as well as actual or predicted power demands or surpluses of the consumers. One parameter controlling the state of each battery cell is the battery cell temperature. Therefore, temperature sensitive elements are provided within the battery module. Meanwhile, some solutions have been provided as how to keep the temperature sensitive element at the surface of the battery cell, since especially in automotive applications there may be strong external impacts. Each of these attempts includes mechanical complex arrangements of fixings with several parts thereby increasing significantly the costs of the battery module due to high manufacturing and material costs.

It is thus an object of the present invention to overcome or reduce at least some of the drawbacks of the prior art and to provide a battery system that may be established by a simple manufacturing process using non-expensive elements.

US 2012/0019061 A1 discloses a battery module where temperature sensitive elements are connected to the electronic control unit by means of a flexible printed circuit board.

### Summary of Invention

One or more of the drawbacks of the prior art could be avoided or at least reduced by means of the present invention. In particular, a battery module is provided comprising:
- at least one battery cell;
- a protective circuit module electrically coupled to the battery cell and including a rigid printed circuit board;
- at least one temperature sensitive element provided at a surface of the battery cell; and
- a flexible printed circuit board electrically connecting the protective circuit module and the temperature sensitive element.

Thus, one aspect of the present invention is to provide a battery module, wherein a position and functionality of the temperature sensitive element at the surface of the battery cell is even ensured when a relative move of the battery cell and the protective circuit module occurs due to external impact. Furthermore, the manufacturing process should be still simply to keep the manufacturing costs low. This is achieved by arranging the temperature sensitive elements directly on the surface of the battery cell and connecting it with the protective circuit module by means of a flexible printed circuit board.

A flexible circuit in its purest form is a vast array of conductors bonded to a thin dielectric film. Flex circuits require less manual labor during assembly and reduce production errors. Flex circuits have an intrinsic ability to integrate form, fit and function. Flex circuits eliminate the high cost of routing, wrapping and soldering wires. As a result, wiring errors are eliminated and hence manufacturing costs are reduced. However, rigid flex circuits provide higher component density and thus the protective circuit module cannot be established as a flexible printed circuit board itself. Hence, the battery module of the present invention combines the benefits of rigid and flexible circuits.

The rigid printed circuit board includes a slit and the flexible printed circuit board is extending from the temperature sensitive element through the slit to an upper surface of the rigid printed circuit board and is being coupled to the protective circuit module at the upper surface of the rigid printed circuit board. In other words, a connection between the temperature sensor and the protective circuit module is achieved at the upper surface of the rigid printed circuit board. The flexible printed circuit board does not pass an outer edge of the rigid printed circuit board to reach the upper surface but passes a designated slit within the rigid printed circuit board. A contact between a wiring pattern of the rigid printed circuit board and the flexible printed circuit board may thus be easily established from the upper side of the battery module, for example by a common soldering process.

According to another embodiment of the present invention, the battery module includes a foam member being arranged between a lower surface of the rigid printed circuit board and the temperature sensitive element. The foam member may be made of an electrically insulating material, especially an elastic polymer material. Such a foam member can be easily provided at the designated place. For example, a flexible printed circuit board provided with a temperature sensitive element at one of its ends may be fixed by an adhesive to a surface of the battery cell. Afterwards, a foam member is placed upon the temperature sensitive element and the other end of the flexible printed circuit board is passed through the slit when the protection circuit module is being mounted. According to an alternative manufacturing process, the foam member may be established after mounting the protective circuit module by means of a foamable compound which is extruded into the gap between the temperature sensitive element and the rigid printed circuit board.

According to a further embodiment of the present invention, a thermally conductive adhesive layer is provided between the temperature sensitive element and the surface of the battery cell. Thereby, the position of the temperature sensitive element on the surface of the battery cell could be fixed. In alternative, the flexible printed circuit board may thus be first soldered to the rigid printed circuit board. The end of the flexible printed circuit board bearing the temperature element is passed through the slit and fixed by the foam element at the rigid printed circuit board. Then, temperature element is fixed at the foam member. During the assembly of the rigid printed circuit board at the top of the battery cells, the temperature element gets pressed to the cell surface. An adhesive between the temperature element and the cell surface may guarantee thermal contact. During the curing of the adhesive the foam member ensures the required contact pressure.

According to another aspect of the present invention, a vehicle including a battery module as defined above is provided. The vehicle may be an automobile.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- FIG. 1: illustrates a perspective view of a battery module.
- FIG. 2: is a partially cut-away cross-sectional view of a battery cell according to the present invention.
- FIG. 3: is an enlarged partially cut-away cross-sectional view perspective view of the battery cell according to FIG. 2.
- FIG. 4: is a perspective view of a part of the battery module including a temperature sensitive element being coupled to a rigid printed circuit board (PCB) via a flexible printed circuit.
- FIG. 5: is a perspective view of a part of the battery module including a temperature sensitive element being coupled to a rigid printed circuit board (PCB) via a flexible printed circuit including a foam member.

### Detailed Description of the Invention

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

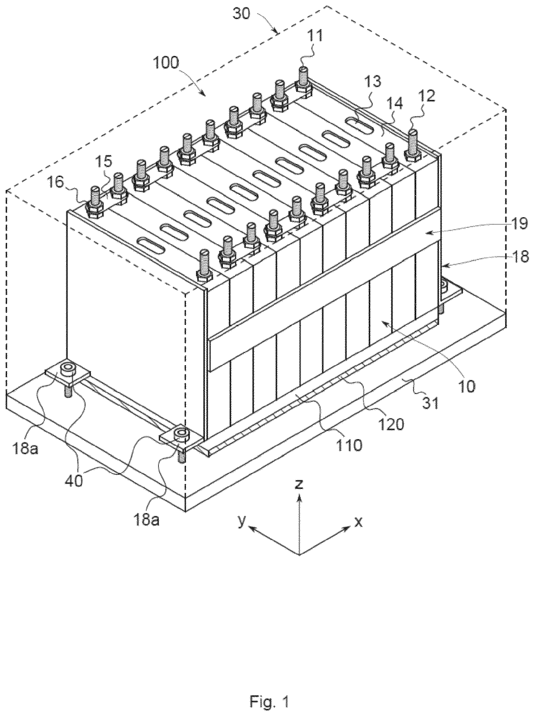

Referring to FIG. 1, an exemplary embodiment of a conventional battery module 100 includes a plurality of battery cells 10 aligned in one direction and a heat exchange member 110 provided adjacent to a bottom surface of the plurality of battery cells 10. A pair of end plates 18 are provided to face wide surfaces of the battery cells 10 at the outside of the battery cells 10, and a connection plate 19 is configured to connect the pair of end plates 18 to each other thereby fixing the plurality of battery cells 10 together. Fastening portions 18a on both sides of the battery module 100 are fastened to a support plate 31 by bolts 40. The support plate 31 is part of a housing 30. In addition, an elastic member 120 made of rubber or other elastic materials may be interposed between the support plate 31 and the heat exchange member 110.

Here, each battery cell 10 is a prismatic (or rectangular) cell, the wide flat surfaces of the cells being stacked together to form the battery module. Further, each battery cell 10 includes a battery case configured for accommodation of an electrode assembly and an electrolyte. The battery case is hermetically sealed by a cap assembly 14. The cap assembly 14 is provided with positive and negative electrode terminals 11 and 12 having different polarities, and a vent 13. The vent 13 is a safety means of the battery cell 10, which acts as a passage through which gas generated in the battery cell 10 is exhausted to the outside of the battery cell 10. The positive and negative electrode terminals 11 and 12 of neighboring battery cells 10 are electrically connected through a bus bar 15, and the bus bar 15 may be fixed by a nut 16 or the like. Hence, the battery module 100 may be used as power source unit by electrically connecting the plurality of battery cells 10 as one bundle. Rechargeable secondary batteries may be used as the battery cells 10, especially lithium secondary batteries. The battery module 100 may be a 48V battery for automotive application.

Generally, the battery cells 10 generate a large amount of heat while being charged/discharged. The generated heat is accumulated in the battery cells 10, thereby accelerating the deterioration of the battery cells 10. Therefore, the battery module 100 further includes a heat exchange member 110, which is provided adjacent to the bottom surface of the battery cells 10 so as to cool down the battery cells 10. Furthermore, the battery module 100 includes means for detecting the temperature of the battery cells 10 in order to safely operate the battery module 100. These means include a protective circuit module and temperature sensors (not shown in FIG. 1).

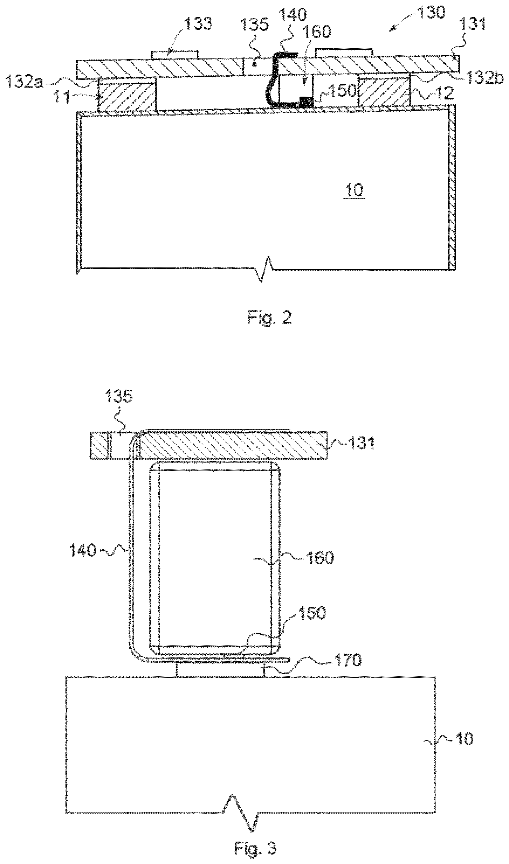

FIG. 2 is a partially cut-away cross-sectional view of one of the battery cells 10 of the battery module 100 of FIG. 1. FIG. 3 is an enlarged and schematic illustration of the area of FIG. 2, where a temperature measurement of the battery cell 10 is performed. Referring to FIG. 2 and respectively FIG. 3, the battery module 100 includes a protective circuit module 130 electrically connected to the battery cell 10. Furthermore, the protective circuit module 130 is electrically connected to a temperature sensitive element 150 via a flexible printed circuit board 140.

In general, each battery cell 10 of the battery module 100 is electrically connected to a protective circuit module 130. According to the present embodiment, there is only one protective circuit module 130, which is connected to all of the battery cells 10 of the battery module 100. However, there may be also two or more separate protective circuit modules being connected to a group of battery cells or single battery cells.

The protective circuit module 130 is made to lie down at sides of the battery cells 10 such that there is a gap between the battery cell surface and the side of the protective circuit module 130 facing the battery cell 10. Here, the protective circuit module 130 is being arranged at the upper surface of the battery cells 10 bearing the electrode terminals 11 and 12. In particular, the protective circuit module 130 is electrically connected to the battery cells 10 to control charging and discharging and preventing the battery cells 10 from being over-charged or over-discharged.

The protective circuit module 130 includes a rigid printed circuit board (PCB) 131 with connection terminals 132a, 132b for the terminals 11, 12 of the battery cell 10 and at least one semiconductor device 133 is formed on an upper surface of the circuit board 131. The semiconductor device 133 may comprise an integrated circuit that is adapted to compare the measured temperature of the battery cell 10 with a limit value for allowable battery cell temperatures. The circuit board 131 includes a wiring pattern (not shown) formed on a surface of the circuit board 131. A main body of the circuit board 131 may be formed of a rigid electrically insulating material like polyimide (PI) or polyethylene (PET). The wiring pattern may be made of an electrically conductive material, such as copper (Cu), titanium (Ti), nickel (Ni), or palladium (Pd).

The connection terminals 132a and 132b may be formed by exposing a portion of the wiring pattern or - as implemented in the present embodiment - by further providing a conductive material, such as gold (Au), on the exposed portion of the wiring pattern.

The semiconductor device 133 applies signals for controlling operations of the battery cells 10. In particular, the semiconductor device 133 controls charging or discharging extents through high current lines of the battery cells 10. In addition, the semiconductor device 133 applies signals indicating voltages, current and temperatures of the battery cells 10 to prevent for example over-charge or over-discharge.

To this end, the semiconductor device 133 applies information about the temperatures of the battery cells 10 via the flexible printed circuit board 140 from the temperature sensitive element 150 and controls the operations of the battery cells 10. Here, the information about the voltages, currents and temperatures may be transferred to the semiconductor device 133 through the wiring pattern of the circuit board 131.

The flexible printed circuit board 140 connects the protective circuit module 130 and the temperature sensitive element 150 provided at a surface of the battery cell 10. According to one embodiment, each battery cell 10 of the battery module 100 includes at least one temperature sensitive element 150 in order to measure the temperature of each battery cell 10 separately. However, in several applications it is sufficient to arrange a minimum of two temperature sensitive elements 150 in the battery module 100.

The flexible printed circuit board 140 includes sensing lines (not shown) for transmitting signals from the connected temperature sensitive element 150 to the protective circuit module 130, thereby allowing the protective circuit module 130 to identify temperature values of the corresponding battery cell 10.

Further, the flexible printed circuit board 140 extends between the protective circuit module 130 and the temperature sensitive element 150. Since the flexible printed circuit board 140 can be easily bent, a stable connection is maintained between the both components even if the battery cells 10 or the protective circuit module 130 move within the housing 30. More precisely, the flexible printed circuit board 140 extends through a slit 135 within the circuit board 131 and one end of the flexible printed circuit board 140 is electrically connected to a wiring pattern of the protective circuit module 130 at the upper surface of the circuit board 131. Thus, there are connectors (not shown) provided at the upper surface of circuit board 131 which may be contacted to sensing lines of the flexible printed circuit board 140 by for example a common soldering process.

The temperature sensitive element 150 is provided on one surface of the battery cell 10. The temperature sensitive element 150 may be a temperature sensor, for instance a negative temperature coefficient (NTC) thermistor, the electrical resistance value of which decreases due to a negative temperature coefficient as the temperature of the battery cells 10 increases, or a positive temperature coefficient (PTC) thermistor, the electrical resistance value of which increases as the temperature of the battery cells 10 increases. Since the temperature sensitive element 150 sensitively reacts to temperature and alters resistance values with temperature, the protective circuit module 130 may control charging and discharging of the battery cells 10.

Specifically, the temperature sensitive element 150 is provided as a chip thermistor. Since the chip thermistor is simply connected to the circuit board 131 of the protective circuit module 130 via the flexible printed circuit board 140 by for example a solder mounting process, the number of overall process steps can be reduced. In addition, such solder mounting can be automated.

In order to fix the temperature sensitive element 150 at the upper surface of the battery cell 10, a foam member 160 is provided between the protective circuit module 130 and a part of the flexible printed circuit board 140 bearing the temperature sensitive element 150. Thus, the temperature sensitive element 150 is pressed on the top side of the battery cell 10 with a foam body inserted between the flexible printed circuit board 140 bearing the temperature sensitive element 150 and the protective circuit module 130. Optionally, the temperature sensitive element 150 may be fixed on the top surface of the battery cell 10 with a thermally conductive adhesive layer 170.

The foam member 160 may be formed of an electrically insulating material. Preferably, the foam member is made of a polymeric material, especially an elastomer which is able to damp relative movements between the battery cell 10 and the protective circuit module 130. Materials useful as foams include for example polyurethanes.

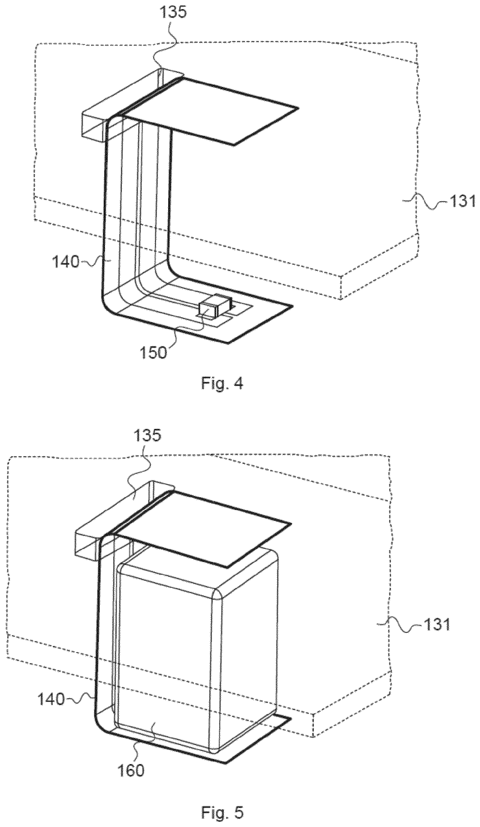

FIG. 4 is a perspective view of a part of the battery module 100 including the temperature sensitive element 150 being coupled to the rigid printed circuit board 131 via the flexible printed circuit 140. For purpose of illustration neither the battery cell 10 nor the foam member 160 is shown and the rigid printed circuit board 131 is semitransparent plotted. As can be seen, the flexible printed circuit board 140 extends through the slit 135 of the rigid printed circuit board 131 from the side facing the battery cell to the side opposite to the battery cell. The flexible printed circuit board 140 is coupled to a wiring pattern (not shown) at the upper surface of the rigid printed circuit board 130.

FIG. 5 is a similar perspective view of a part of the battery module 100 as illustrated in FIG. 4 except that the foam member 160 is also illustrated.

## Claims

1. A battery module (100), comprising:
- at least one battery cell (10);
- a protective circuit module (130) electrically coupled to the battery cell (10) and including a rigid printed circuit board (131);
- at least one temperature sensitive element (150) provided at a surface of the battery cell (10); and
- a flexible printed circuit board (140) electrically connecting the protective circuit module (130) and the temperature sensitive element (150),
**characterized in that** the rigid printed circuit board (131) includes a slit (135) and
wherein the flexible printed circuit board (140) is extending from the temperature sensitive element (150) through the slit (135) to an upper surface of the rigid printed circuit board (131) and is being coupled to the protective circuit module (130) at the upper surface of the rigid printed circuit board (131).

2. The battery module of claim 1, wherein the battery module (100) includes a foam member (160) being arranged between a lower surface of the rigid printed circuit board (131) and the temperature sensitive element (150).

3. The battery module of one of the preceding claims, wherein the foam member (160) is made of an electrically insulating material.

4. The battery module of one of the preceding claims, wherein the foam member (160) directly contacts the temperature sensitive element (150) on the top side of the battery cell (10).

5. The battery module of one of the preceding claims, wherein a thermally conductive adhesive layer (170) is provided between the temperature sensitive element (150) and the surface of the battery cell (10).

6. A vehicle including a battery module according to one of the preceding claims.

## Patentansprüche

1. Ein Batteriemodul (100), aufweisend:
- zumindest eine Batteriezelle (10);
- ein Schutzschaltungsmodul (130), das mit der Batteriezelle (10) elektrisch gekoppelt ist und eine starre Leiterplatte (131) aufweist;
- zumindest ein temperaturempfindliches Element (150), das an einer Oberfläche der Batteriezelle (10) bereitgestellt wird; und
- eine flexible Leiterplatte (140), die das Schutzschaltungsmodul (130) und das temperaturempfindliche Element (150) elektrisch verbindet,
**dadurch gekennzeichnet, dass** die starre Leiterplatte (131) einen Schlitz (135) aufweist, und
wobei sich die flexible Leiterplatte (140) vom temperaturempfindlichen Element (150) durch den Schlitz (135) zu einer Oberseite der starren Leiterplatte (131) erstreckt und an der Oberseite der starren Leiterplatte (131) mit dem Schutzschaltungsmodul (130) gekoppelt ist.

2. Das Batteriemodul nach Anspruch 1, wobei das Batteriemodul (100) ein Schaumelement (160), das zwischen einer Unterseite der starren Leiterplatte (131) und dem temperaturempfindlichen Element (150) angeordnet ist, aufweist.

3. Das Batteriemodul nach einem der vorhergehenden Ansprüche, wobei das Schaumelement (160) aus einem elektrisch isolierenden Material besteht.

4. Das Batteriemodul nach einem der vorhergehenden Ansprüche, wobei das Schaumelement (160) auf der Oberseite der Batteriezelle (10) direkt mit dem temperaturempfindlichen Element (150) in Kontakt steht.

5. Das Batteriemodul nach einem der vorhergehenden Ansprüche, wobei eine wärmeleitende Haftschicht (170) zwischen dem temperaturempfindlichen Element (150) und der Oberfläche der Batteriezelle (10) bereitgestellt wird.

6. Ein Fahrzeug, aufweisend ein Batteriemodul nach einem der vorhergehenden Ansprüche.

## Revendications

1. Module de batteries (100) comprenant :
- au moins un élément de batterie (10) ;
- un module de circuits protecteurs (130) couplé électriquement à l'élément de batterie (10) et comprenant une carte de circuit imprimé rigide (131) ;
- au moins un élément thermosensible (150) disposé au niveau d'une surface de l'élément de batterie (10) ; et
- une carte de circuit imprimé flexible (140) connectant électriquement le module de circuits protecteurs (130) et l'élément thermosensible (150),
**caractérisé en ce que** la carte de circuit imprimé rigide (131) comprend une fente (135), et
dans lequel la carte de circuit imprimé flexible (140) s'étend depuis l'élément thermosensible (150) à travers la fente (135) jusqu'à une surface supérieure de la carte de circuit imprimé rigide (131) et est couplée au module de circuits protecteurs (130) au niveau de la surface supérieure de la carte de circuit imprimé rigide (131).

2. Module de batteries selon la revendication 1, lequel module de batteries (100) comprend un élément en mousse (160) qui est agencé entre une surface inférieure de la carte de circuit imprimé rigide (131) et l'élément thermosensible (150).

3. Module de batteries selon l'une des revendications précédentes, dans lequel l'élément en mousse (160) est fait en un matériau électriquement isolant.

4. Module de batteries selon l'une des revendications précédentes, dans lequel l'élément en mousse (160) est en contact direct avec l'élément thermosensible (150) sur le côté supérieur de l'élément de batterie (10).

5. Module de batteries selon l'une des revendications précédentes, dans lequel une couche adhésive thermiquement conductrice (170) est disposée entre l'élément thermosensible (150) et la surface de l'élément de batterie (10).

6. Véhicule comprenant un module de batteries selon l'une des revendications précédentes.
